# FASCICULE DE BREVET EUROPEEN

(11) **EP 1 628 332 B1**
(45) Date de publication et mention de la délivrance du brevet: **22.06.2022**
(21) Numéro de dépôt: 05291731.7
(22) Date de dépôt: 16.08.2005
(51) Int. Cl.: H01L 21/265, H01L 29/66

(54) **Procédé de fabrication d'un élément en couches minces**
Herstellung eines Dünnschichtbauelements
Method of fabricating a thin film device

(30) Priorité: 19.08.2004 FR 0408989
(43) Date de publication de la demande: 22.02.2006
(73) Titulaire: Commissariat à l'Énergie Atomique et aux Énergies Alternatives, 75015 Paris (FR)
(72) Inventeur: Barbe, Jean-Charles, 38100 Grenoble (FR); Vinet, Maud, 38140 Rives (FR); Faynot, Olivier, 38170 Seyssinet-Pariset (FR)
(74) Mandataire: Santarelli

(56) Documents cités:
- US-A- 5 221 630
- US-B1- 6 225 151
- US-B1- 6 495 401
- WOLF S ET AL: "Ion Implantation for VLSI", 1 January 1986 (1986-01-01), SILICON PROCESSING FOR THE VLSI ERA. VOLUME 1: PROCESS TECHNOLOGY, LATTICE PRESS, SUNSET BEACH, CALIFORNIA, USA, PAGE(S) 280 - 330, XP002489661, ISBN: 978-0-9616721-3-3

## Description

L'invention concerne un procédé de fabrication d'un élément en couches minces. Il s'agit en particulier d'un élément en couches minces pour un composant électronique.

Dans les procédés de fabrication des composants électroniques, il est fréquent d'utiliser des éléments qui se composent d'une couche réalisée dans un premier matériau et qui porte un motif réalisé dans un second matériau, par exemple sous forme d'une couche mince.

Ce type de structure apparaît notamment dans la technologie dite "*silicium sur isolant*", parfois dénommée simplement par l'appellation SOI (de l'anglais "*Silicon-On-Insulator*'), utilisée par exemple dans la demande de brevet FR 2 827 705 pour la réalisation d'un transistor.

Le document US 6495401 B1 décrit une méthode de préparation d'une plaque de silicium sur isolant, comprenant la formation d'une couche supérieure en silicium sur une couche d'oxyde de silicium ; la méthode comprend en outre une étape d'implantation avec des ions phosphore.

En effet, selon cette technique, une couche généralement dénommée couche enterrée et réalisée en matériau isolant sépare le motif, qui participe à la réalisation de la partie électroniquement active (par exemple un transistor), du substrat massif en silicium.

Au cours de la fabrication de l'élément en couches minces, il peut être nécessaire d'augmenter localement l'épaisseur du motif par exemple par une technique d'épitaxie. Au moment de cette étape, la couche enterrée en matériau isolant porte un motif de silicium de faible épaisseur. Afin de réaliser un nettoyage de cette structure, il est nécessaire de la soumettre à une température élevée pour provoquer une désorption d'espèces.

L'application d'une température élevée (typiquement de l'ordre de 850°C) active le phénomène de diffusion de surface.

Lorsque l'épaisseur du motif est très limitée (typiquement de l'ordre de la dizaine de nanomètres ou moins), ce qui est de plus en plus fréquent avec la réduction continue de la taille des composants microélectroniques, cette diffusion peut transformer le motif, initialement sous forme d'un bloc uniforme, en un ensemble de cristaux disjoints les uns les autres, qui correspondent à la forme d'équilibre qui minimise l'énergie du système.

Un tel phénomène, dénommé phénomène d'agglomération, est bien entendu désastreux pour la poursuite du procédé de fabrication.

Afin notamment de répondre à ce problème, et ainsi de proposer une solution selon laquelle notamment un motif en couche mince porté par une couche enterrée puisse être soumis à des températures élevées (par exemple pour nettoyage par désorption d'espèces), l'invention propose un procédé de fabrication d'un élément en couches minces, dans lequel une couche d'un premier matériau porte un motif d'un second matériau, caractérisé par une étape de dopage par implantation d'une espèce chimique sur une partie au moins de l'ensemble couche-motif de manière à stabiliser le motif sur la couche.

Les espèces implantées sont ainsi aptes à modifier l'énergie de surface de la couche et/ou l'énergie d'interface entre le motif et la couche. La stabilisation porte principalement sur la géométrie du motif.

Selon une première solution, l'implantation est réalisée au moins sur une partie de la couche située à la périphérie d'une zone support du motif de manière à modifier les propriétés surfaciques de ladite partie. On modifie ainsi les angles de contact, ce qui améliore la tenue du motif.

La présence d'espèces implantées au niveau des régions périphériques de la zone de la couche qui porte le motif modifie les énergies de surface de la couche et/ou d'interface entre le motif et la couche et donc l'angle de contact à l'équilibre thermodynamique, encore appelé angle de Young (ou angle de contact dans la suite du document).

L'implantation doit permettre de diminuer l'angle de Young pour ainsi diminuer la cinétique d'évolution du motif et limiter l'agglomération pendant le temps de recuit, par exemple pour nettoyage par désorption d'espèces.

Lorsque le motif est porté par une face de la couche et que la face comprend une région qui jouxte et entoure au moins en partie le motif, l'implantation est par exemple réalisée au moins en partie sur ladite région.

On peut prévoir que l'étape d'implantation laisse essentiellement inchangée la composition chimique d'au moins une partie de la zone de la couche située directement sous le motif (zone support du motif).

On peut également prévoir une étape de diffusion latérale de l'espèce implantée par recuit, de manière à doper en espèce implantée les régions périphériques de la zone support du motif. Ceci est notamment intéressant si l'angle de Young est supérieur à 90° dans les régions non dopées (car, dans ce cas, aucun étalement du motif n'intervient).

Le motif peut être recouvert par un masque lors de l'étape d'implantation.

Dans ce cas, le procédé peut éventuellement comprendre une étape préalable de formation du motif par photo-lithogravure à l'aide du masque.

En variante, le motif pourrait être reporté et rendu solidaire de la couche par adhésion moléculaire.

Selon une deuxième solution, éventuellement compatible avec la première, l'implantation est réalisée au moins en partie dans le motif.

Le premier matériau peut être un isolant, par exemple un oxyde de silicium.

Le second matériau peut être un matériau semi-conducteur, par exemple du silicium.

L'implantation est réalisée avec une profondeur typique inférieure à la moitié de l'épaisseur de la couche. Il s'agit en général d'une profondeur typique inférieure à 50 nm, par exemple de l'ordre de 10 nm. Ainsi, l'implantation surfacique ne modifie pas les propriétés volumiques de la couche concernée.

Par ailleurs, l'implantation est réalisée avec une incidence non nulle, par exemple comprise entre 5° et 45°. Ainsi, on peut obtenir un dopage qui déborde légèrement sous le motif avec les avantages déjà mentionnés plus haut (cas de la diffusion latérale).

L'étape de dopage peut être postérieure à une étape de réalisation du motif. Elle peut également être antérieure à l'étape de réalisation du motif ou contemporaine de cette étape.

Le motif a en général une épaisseur inférieure à 15 nm, auquel cas les risques d'agglomération mentionnés plus haut sont particulièrement élevés. L'intérêt du procédé proposé est d'ailleurs accru pour des motifs de très faible épaisseur, typiquement inférieure à 10 nm, voire inférieure à 5 nm.

Le procédé peut alors comprendre, postérieurement à l'étape d'implantation et à une étape de réalisation du motif, une étape d'application d'une température pendant une durée donnée, la température et la durée étant telles qu'elles entraîneraient l'agglomération de motifs identiques audit motif portés par des couches identiques à ladite couche pour des ensembles n'ayant pas subi l'implantation. Il s'agit par exemple d'une étape de préparation de surface en vue d'une épitaxie.

Dans un exemple non compris dans l'invention revendiquée, il est proposé également un élément en couches minces comprenant une couche d'un premier matériau qui porte un motif d'un second matériau, caractérisé par une région dopée en une espèce chimique sur une partie au moins de l'ensemble couche-motif de manière à stabiliser le motif sur la couche.

Selon une première solution, ladite région est située notamment sur une partie de la surface de la couche située à la périphérie d'une zone support du motif de manière à modifier les propriétés surfaciques de la couche.

Selon une deuxième solution, éventuellement compatible avec la première, ladite région est située au moins en partie dans le motif.

Par ailleurs, l'élément peut comporter des caractéristiques analogues à celles mentionnées ci-dessus pour le procédé, avec les avantages qui en découlent.

D'autres caractéristiques et avantages de l'invention apparaîtront à la lecture de la description qui suit, faite en référence aux dessins annexés dans lesquels:
- les figures 1 à 5 représentent des étapes d'un procédé de fabrication d'un élément en couches minces conformément à un premier mode de réalisation qui ne fait pas partie de l'invention revendiquée ;
- les figures 6 et 7 représentent des profils de concentration en espèce implantée obtenus par ce procédé, respectivement dans le masque et dans la couche enterrée ;
- les figures 8 et 9 illustrent les étapes d'une première variante du premier mode de réalisation selon l'invention ;
- la figure 10 représente une seconde variante du premier mode de réalisation selon l'invention ;
- les figures 11 à 13 représentent des étapes d'un procédé de fabrication d'un élément en couches minces conformément à un second mode de réalisation non compris dans l'invention revendiquée ;
- les figures 14 à 16 représentent des étapes d'un procédé de fabrication d'un élément en couches minces conformément à un troisième mode de réalisation non compris dans l'invention revendiquée ;
- les figures 17 à 19 représentent des étapes d'un procédé de fabrication d'un élément en couches minces conformément à un quatrième mode de réalisation non compris dans l'invention revendiquée.

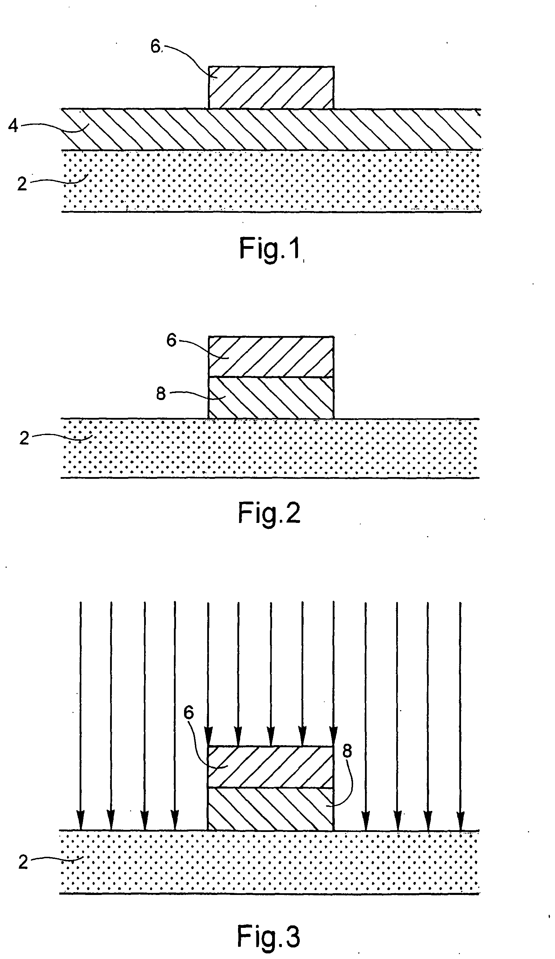

La figure 1 représente l'élément en couches minces au stade du procédé de fabrication où celui-ci comporte une couche inférieure continue 2 réalisée en matériau isolant, recouverte par une couche continue 4 réalisée en matériau semi-conducteur. La couche en matériau isolant 2 est de ce fait dénommée couche enterrée.

La couche enterrée est par exemple réalisée en oxyde de silicium (SiO₂) et dénommée dans ce cas BOX, acronyme de l'anglais "Buried OXide". La couche en matériau semi-conducteur 4 est par exemple réalisée en silicium (Si).

Cette structure est la structure de base en technologie silicium sur isolant ou SOI. Elle peut être obtenue par le procédé décrit dans le brevet US 5 374 564. La couche en silicium 4 est destinée à former les éléments microélectroniques actifs du composant électronique après traitements adéquats.

La couche d'oxyde 2 est quant à elle destinée à isoler ces parties actives par rapport au substrat en silicium massif qui porte la structure précédemment décrite.

Comme déjà indiqué, à l'étape du procédé représenté à la figure 1, la couche en silicium 4 est continue. Un masque 6, réalisé par exemple sous forme d'une bicouche oxyde de silicium (SiO₂)/nitrure de silicium (le SiO₂ étant au contact du motif de silicium), est déposé sur la face supérieure de la couche de silicium 4 afin de définir la forme d'un motif par photo-lithogravure.

La figure 2 représente en effet la structure en couches minces de la figure 1 après une étape de photo-lithogravure.

La couche enterrée 2 n'est pas modifiée par cette étape, alors que la couche de silicium 4 a été éliminée, sauf dans les régions où elle était recouverte par le masque 6.

La couche enterrée 2 porte ainsi un motif en couche mince 8 en silicium, qui est toujours recouvert à cette étape par le masque 6.

Comme illustré à la figure 3, on soumet alors la structure ainsi obtenue à une étape d'implantation d'espèces chimiques, par exemple des atomes d'arsenic (As) ou de phosphore (P). En variante, il pourrait s'agir d'une implantation de molécules, par exemple du type BF₂. Les espèces sont par exemple implantées sous forme ionique.

Les espèces implantées doivent participer à la diminution de l'angle de contact entre le motif et son support. Si ces ions doivent aussi avoir un rôle électrique par la suite, il est intéressant d'implanter des donneurs ou des accepteurs d'électrons, respectivement situés à droit et à gauche du silicium dans le tableau de Mendeleïev (ou classification périodique des éléments).

Les paramètres de l'implantation sont choisis tels que celle-ci n'affecte l'élément en couches minces de la figure 2 qu'en surface. Par exemple, lorsque la couche enterrée 2 a une épaisseur de l'ordre de 100 nm, l'implantation est réalisée avec une profondeur typique de l'ordre de 10 nm.

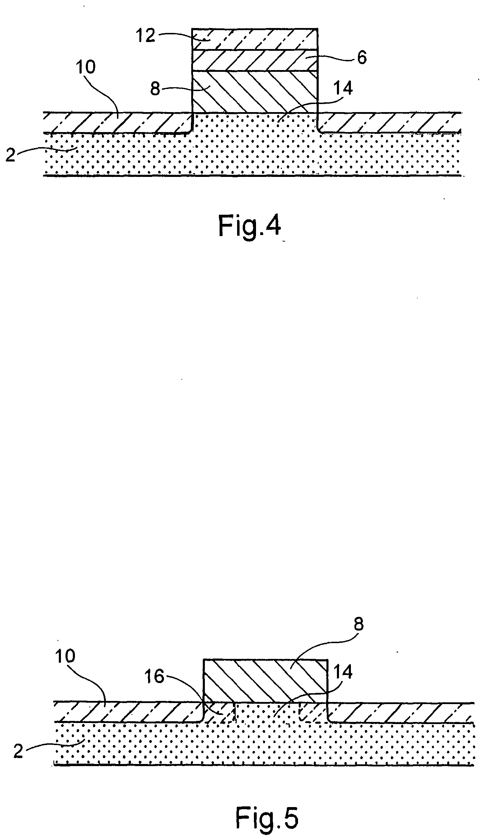

Après implantation, comme représenté en figure 4, la composition chimique en surface des matériaux qui formaient la structure représentée à la figure 2 est donc modifiée.

En particulier, les régions situées en surface au niveau de la face supérieure de la couche enterrée 2 sont dopées par l'espèce chimique implantée, et ce au moins à la périphérie de la zone 14 de la couche enterrée 2 située directement sous le motif en couche mince 8 (dénommée zone support 14 dans la suite). On forme ainsi, dans des régions de la face supérieure de la couche enterrée 2 qui jouxtent et entourent le motif en couche mince 8, une couche de surface 10 dopée en espèce chimique implantée. On modifie ainsi les propriétés surfaciques, et notamment l'énergie d'interface entre la couche enterrée 2 et le motif mince 8, ce qui modifie l'angle de contact (classiquement appelé angle de Young) entre le motif mince 8 et la couche enterrée 2.

Avantageusement, pour favoriser la diffusion latérale des espèces implantées sous le motif, on pourra effectuer un traitement thermique (par exemple à 950° pendant 2 min) comme indiqué plus bas. Le temps et la température de ce recuit pourront être modifiés par l'homme du métier pour obtenir l'extension requise.

Naturellement, comme représenté sur la figure 4, le masque subit également l'implantation. Toutefois, dans l'exemple décrit ici, l'implantation est réalisée de telle sorte qu'elle ne traverse pas le masque 6 ; ainsi, le motif en couche mince 8 n'est pas atteint par l'implantation (ou atteint très faiblement par celle-ci comme illustré ci-dessous).

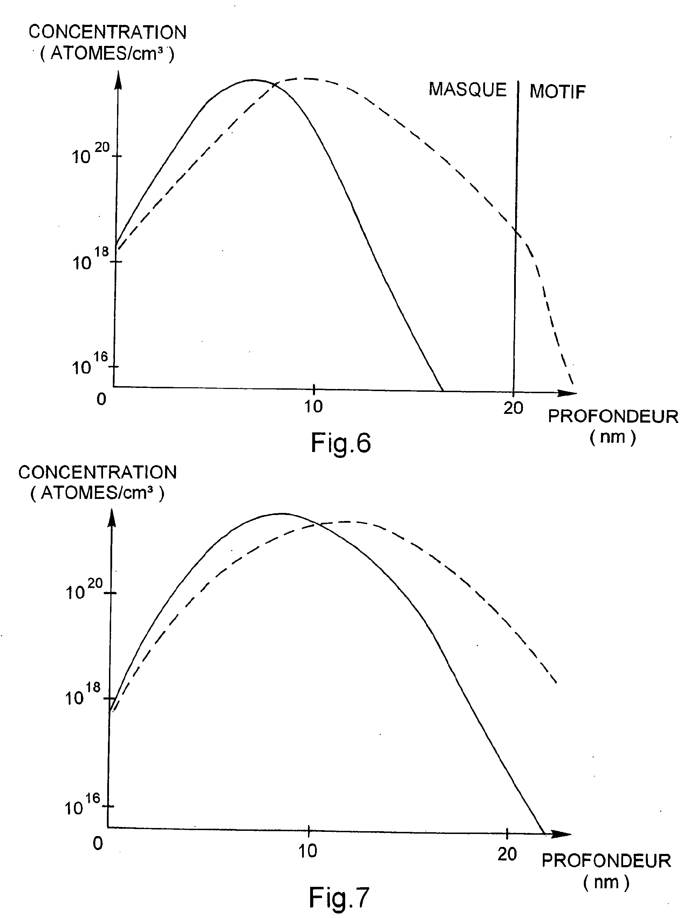

Des exemples de profils de concentration de l'espèce implantée obtenus par l'étape qui vient d'être décrite sont représentés sur les figures 6 et 7.

La figure 6 représente le profil en concentration en arsenic dans la profondeur du masque 6 et du motif 8. L'abscisse du graphique de la figure 6 représente la profondeur en nanomètres par rapport à la face supérieure (libre) du masque 6. Le masque 6 ayant une épaisseur de 20 nm dans l'exemple représenté, les valeurs d'abscisse de 0 à 20 représentent des points situés dans le masque, alors que les valeurs d'abscisse de valeur supérieure à 20 correspondent à des points situés dans le motif 8. La concentration en atomes par cm³ est représentée en ordonnée en échelle logarithmique.

Le trait continu illustre le profil de concentration obtenu par implantation d'arsenic (As) avec une énergie de 5 keV, alors que le trait pointillé illustre le profil de concentration pour une énergie de 10 keV, toujours dans le cas de l'arsenic (As).

Comme bien visible sur la figure 6, dans les deux cas (5 ou 10 keV), la profondeur d'implantation de l'arsenic (As) est de l'ordre de 10 nm.

Dans le premier cas (énergie de 5 keV), la profondeur typique d'implantation (c'est-à-dire la profondeur où l'on génère la plus forte concentration en espèce implantée par l'implantation) est légèrement inférieure à 10 nm et la concentration en atomes d'arsenic (As) chute fortement au-delà de 10 nm, de telle sorte qu'elle est négligeable au niveau de l'interface masque-motif, et dès lors également négligeable à l'intérieur du motif 8.

Dans le second cas (énergie de 10 keV), la profondeur typique d'implantation est très légèrement supérieure à 10 nm et la concentration en atomes d'arsenic au niveau de l'interface masque-motif est de l'ordre de celle que l'on peut observer sur la face supérieure du masque. Par conséquent, dans ce cas, le motif subit une légère implantation qui ne peut pas être négligée, comme cela apparaît clairement sur la figure 6.

Naturellement, on utilisera une implantation du type obtenue ci-dessus avec une énergie de 5 keV lorsque l'on souhaite éviter d'obtenir une implantation, même légère, de l'espèce chimique dans le motif, comme par exemple dans le cas d'un transistor pour lequel le canal n'est pas dopé (dopage dit intrinsèque correspondant à la concentration naturelle des porteurs) alors que les zones d'accès (source et drain) seront dopées N (pour un NMOS) ou P (pour un PMOS).

L'implantation du motif ne se révèle toutefois pas néfaste dans tous les cas, comme nous le verrons en détail dans la suite à propos du second mode de réalisation.

La figure 7 représente le profil de concentration en atomes d'arsenic (As) dans la couche enterrée 2. L'échelle des abscisses représente la profondeur dans la couche enterrée 2 par rapport à la face supérieure de la couche enterrée 2 qui reçoit l'implantation. Comme pour la figure 6, l'échelle des ordonnées représente la concentration d'atomes d'arsenic par cm³.

Dans le cas où une implantation d'énergie 5 keV est utilisée (trait plein sur la figure 7), la profondeur typique d'implantation est très légèrement inférieure à 10 nm. On peut remarquer qu'elle est très légèrement supérieure à la profondeur d'implantation obtenue avec la même énergie dans le masque 6 réalisé en nitrure.

Dans le cas où une énergie de 10 keV est utilisée (trait pointillé sur la figure 7), la profondeur d'implantation est de l'ordre de 15 nm.

Lorsque l'implantation est réalisée, on peut éventuellement procéder à une étape de recuit afin d'assurer la diffusion latérale des espèces implantées dans la couche enterrée 2.

On obtient alors un dopage des régions périphériques 16 de la zone 14 qui porte le motif 8, comme représenté en pointillés sur la figure 5.

On peut toutefois remarquer que cette diffusion n'est pas toujours nécessaire, en particulier si l'angle de Young est inférieur à 90°. En effet, dans ce cas, le pied de gravure commence par s'étaler latéralement. S'il atteint une zone dopée dont l'angle est adapté, la cinétique d'agglomération du film sera modifiée comme prévu par l'invention.

De manière classique, le masque 6 utilisé pour la mise en place de la structure en couches minces est éliminé à une étape ultérieure, après laquelle on obtient pour l'élément de composant électronique la structure suivante, représentée à la figure 5 :
- une couche enterrée continue 2 ici en oxyde de silicium, dont la face supérieure comporte des régions dopées 10 en surface par implantation ;
- un motif en couche mince 8, ici réalisé en silicium, porté par la couche enterrée 2 au niveau de la zone support 14 dont la partie centrale n'a pas subit d'implantation et dont les régions périphériques 16 peuvent être dopées en cas d'utilisation de l'étape de recuit.

Du fait que les régions dopées 10 se situent notamment à la périphérie de la zone 14 support du motif en couche mince 8, celui-ci est comme retenu dans un puits d'énergie grâce à la modification des angles de contact précédemment mentionnée, de telle sorte que la vitesse de démouillage entre le motif mince et la couche enterrée est réduite de façon notable. On augmente ainsi l'énergie d'ancrage du motif mince 8.

La structure représentée à la figure 5 et obtenue grâce au procédé proposé peut ainsi être soumise à des températures élevées, par exemple pour nettoyage par désorption, sans risquer la destruction du motif 8 par diffusion de surface. A titre d'exemple, la structure pourra subir une préparation de surface en vue d'une épitaxie, par recuit sous atmosphère hydrogénée, typiquement à 850°C pendant 10 minutes.

Par ailleurs, du fait de la profondeur d'implantation utilisée typiquement de l'ordre de 10 nm, contre typiquement 100 nm d'épaisseur pour la couche enterrée, seules les propriétés surfaciques de la couche enterrée 2 sont modifiées par l'implantation, de telle sorte que ses propriétés volumiques (notamment ici, l'isolation réalisée par la couche enterrée 2) ne sont pas modifiées. Ainsi, si l'implantation permet une meilleure tenue du motif 8 sur la couche enterrée 2, elle ne remet pas en cause les avantages que procure classiquement cette structure.

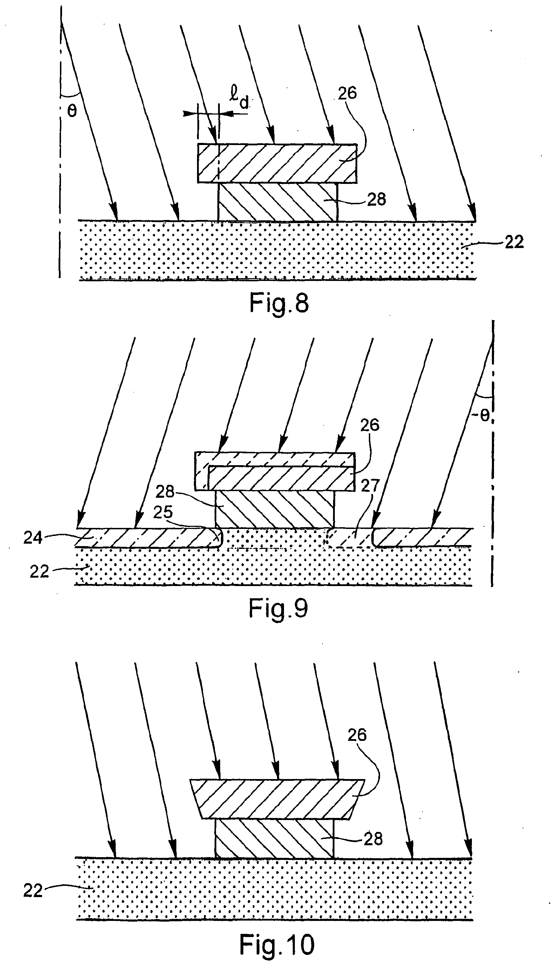

Les figures 8 et 9 représentent une variante du procédé décrit ci-dessus en référence aux figures 1 à 5, selon laquelle l'implantation est réalisée avec une incidence θ non nulle, par exemple 7°. On choisira en général une incidence comprise entre 0° et 45°.

Comme on le verra, l'utilisation d'une incidence non nulle permet de réaliser l'implantation non seulement dans les régions de la surface de la couche enterrée qui entourent et jouxtent le motif, mais également dans les régions périphériques 25 de la zone de la couche enterrée qui porte le motif (zone support du motif), sans avoir besoin d'un recuit complémentaire comme mentionné précédemment, même si ce recuit peut être effectué.

Selon cette première variante, on peut prévoir que le masque 26 déborde latéralement par rapport au motif en couche mince 28 porté par la couche enterrée isolante 22 afin que le masque 26 protège le motif 28 par rapport à l'implantation sous incidence θ. L'utilisation d'un tel débordement du masque 26 est naturellement d'un intérêt particulier lorsque l'on souhaite éviter le dopage par l'espèce chimique implantée du motif 28, comme dans le cas du transistor à canal non dopé déjà mentionné.

Afin de jouer correctement son rôle de protection du motif 28, le masque 26 doit déborder par rapport à celui-ci d'une distance I_{d} au moins égale à : Lₚ.sinθ + tₛᵢ.tanθ, où Lₚ correspond à la profondeur typique d'implantation et t_{Si} correspond à l'épaisseur du motif.

Si on utilise une implantation sous forme d'un faisceau parallèle d'ions sous incidence 0 comme représenté à la figure 8, on réalise à la surface supérieure de la couche enterrée 22 des régions 24 dopées en espèce chimique implantée non seulement au niveau de la surface libre de la couche enterrée 22, mais également dans les régions périphériques 25 de la zone de la couche enterrée 22 située directement sous le motif en couche mince 28, comme illustré sur la figure 9. Une telle implantation permet une meilleure tolérance vis-à-vis des étapes ultérieures de procédés de fabrication qui consomment en partie la couche support du motif en couche mince.

Comme visible sur la figure 9, l'implantation avec une incidence 0 donnée non nulle provoque toutefois une dissymétrie des régions dopées (représentées en trait plein), c'est pourquoi il est préférable de prévoir également, comme représenté à la figure 9, une étape d'implantation sous même incidence, mais en faisant pivoter la plaquette autant de fois que nécessaire. Classiquement l'homme du métier choisit quatre rotations de 90°. Comme bien visible sur la figure 9, cette nouvelle étape permet de compléter l'implantation de la surface libre de la couche enterrée 22, notamment dans les parties 27 de celle-ci (représentées en pointillés) qui étaient abritées par le masque 26 lors de l'implantation avec incidence θ.

On profite à cette étape du débordement symétrique du masque 26 par rapport au motif 28 qui permet de protéger la paroi latérale du motif 28 qui serait soumise à l'implantation d'incidence non nulle sans ce débordement.

Naturellement, d'autres côtés du motif 28 non représentés sur les figures 8 et 9 peuvent également nécessiter chacun une implantation avec une orientation différente (qui conserve toutefois toujours un angle θ avec la normale à la couche enterrée 22).

Le débordement du masque 26 peut avoir une forme différente de celle représentée à la figure 8. Par exemple, les flans du masque 26 peuvent être inclinés d'un angle égal à, ou en pratique d'une valeur proche de, l'angle d'implantation 8, comme représenté à la figure 10. Cette solution est notamment avantageuse car elle évite les phénomènes d'ombrage.

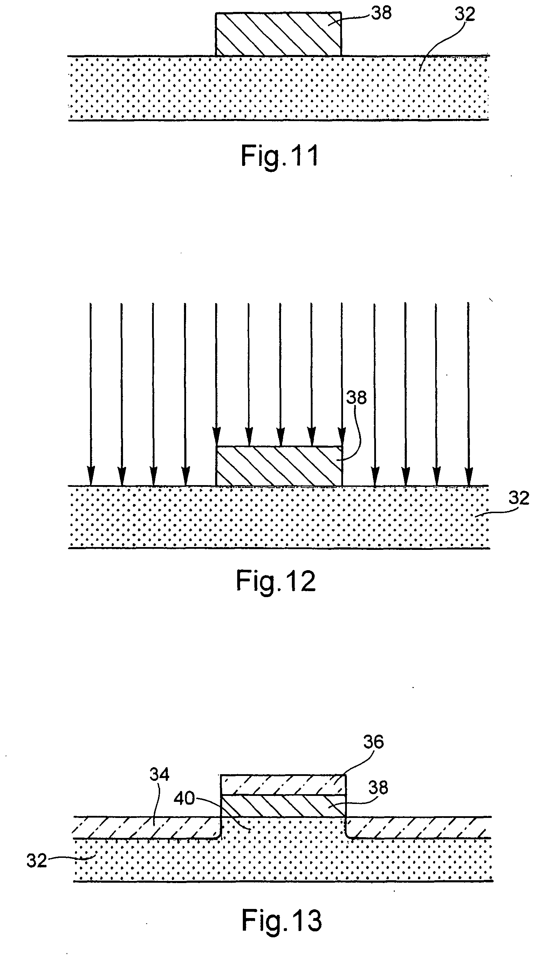

On va à présent décrire un second mode de réalisation non compris dans l'invention revendiquée en référence aux figures 11 à 13.

Dans ce second mode de réalisation, on considère un élément en couches minces dans lequel une couche enterrée 32 porte sur sa face supérieure un motif 38, dont la face supérieure est libre, comme représenté à la figure 11, ou recouverte d'un oxyde fin, par exemple un oxyde déposé de 20 Å (soit 2 nm) typiquement, dont l'une des fonctions est de limiter l'endommagement induit par le bombardement ionique à venir.

Une telle structure est par exemple obtenue par photo-lithogravure. Pour ce faire, on peut notamment utiliser un procédé avec des étapes identiques à celles représentées sur les figures 1 et 2 du premier mode de réalisation, suivies d'une étape d'élimination du masque (sans avoir procédé à ce stade à l'étape d'implantation, et ce contrairement au premier mode de réalisation).

On procède alors à une étape d'implantation d'une espèce chimique, par exemple des atomes d'arsenic, comme schématiquement représenté à la figure 12. Les paramètres de l'implantation sont tels que celle-ci modifie principalement la composition chimique des couches surfaciques de la couche enterrée 32. Ceci est obtenu par exemple lorsque la profondeur typique d'implantation est nettement inférieure à l'épaisseur de la couche enterrée 32.

Comme indiqué précédemment, la face supérieure du motif mince 38 est libre, et subit par conséquent également l'implantation, avec une profondeur proportionnelle à la densité du matériau implanté. Pour un support en oxyde de silicium (SiO₂) et un motif en silicium, les profondeurs d'implantation sont donc sensiblement égales, si on néglige les effets de canalisation qui peuvent avoir lieu dans le silicium lorsque les rangées d'atomes de silicium sont parallèles à la direction d'implantation.

Toutefois, de manière avantageuse, l'épaisseur du motif mince 38 est inférieure à l'épaisseur de la couche enterrée 32 de telle sorte qu'il possible de choisir une profondeur d'implantation qui permette un dopage en espèce implantée des couches surfaciques seulement de la couche enterrée 32, mais, en revanche, d'une partie substantielle (en terme de profondeur notamment) du motif en couche mince 36.

On remarque en outre que la profondeur d'implantation est avantageusement inférieure à l'épaisseur du motif en couche mince 36 de telle sorte que la zone de la couche enterrée 32 située directement sous le motif mince 36 n'est pas atteinte, ou en tout cas pas de manière substantielle, par l'implantation.

L'implantation qui vient d'être décrite permet ainsi d'obtenir un élément en couche mince dans lequel la couche enterrée 32 possède en surface des régions 34 dopées en espèces implantées, sauf dans la zone 40 de la surface de la couche enterrée 32 directement située sous le motif mince 38, et dans lequel le motif mince 38 lui-même est dopé, au moins dans des parties substantielles 36, en espèce implantée. Une partie enterrée du motif mince 38, n'ayant pas subi l'implantation, reste cristalline. Au besoin, elle pourra servir de germe de recristallisation pour la partie supérieure du motif amorphisée par l'implantation, au cours d'un traitement thermique ultérieur adapté.

Grâce à la présence de ces régions implantées 34, 36 tant à la surface de la couche enterrée 32 qu'au sein du motif en couche mince 38, les deux phénomènes physiques suivants peuvent coopérer dans le but d'éviter le démouillage du motif mince 38 :
- un phénomène de modification des énergies de surface de la couche enterrée 32 dans les régions 34 de celle-ci qui ne portent pas le motif mince 38, de façon à modifier les angles de contact (de manière analogue à l'effet produit dans le premier mode de réalisation) ;
- un phénomène de réduction de la vitesse de diffusion en surface de la couche mince 38 par le dopage d'au moins une partie substantielle 36 de celle-ci.

Ces deux phénomènes concourent au maintien du motif mince sous forme d'une masse compacte, et ce notamment lorsque l'élément en couche mince est soumis à des températures élevées, par exemple pour nettoyage par désorption.

Comme cela apparaît clairement, l'utilisation conjointe de ces deux phénomènes implique toutefois que le dopage du motif mince 38 ne pose pas de problème pour l'utilisation future de l'élément en couche mince ainsi obtenu. C'est pourquoi on utilisera ce second mode de réalisation par exemple dans les cas où le motif mince ne doit pas assurer de fonction électrique, mais uniquement une fonction mécanique.

Selon une autre possibilité de réalisation dont des exemples vont à présent être donnés, l'implantation peut être réalisée avant que la structure couche-motif ne soit constituée.

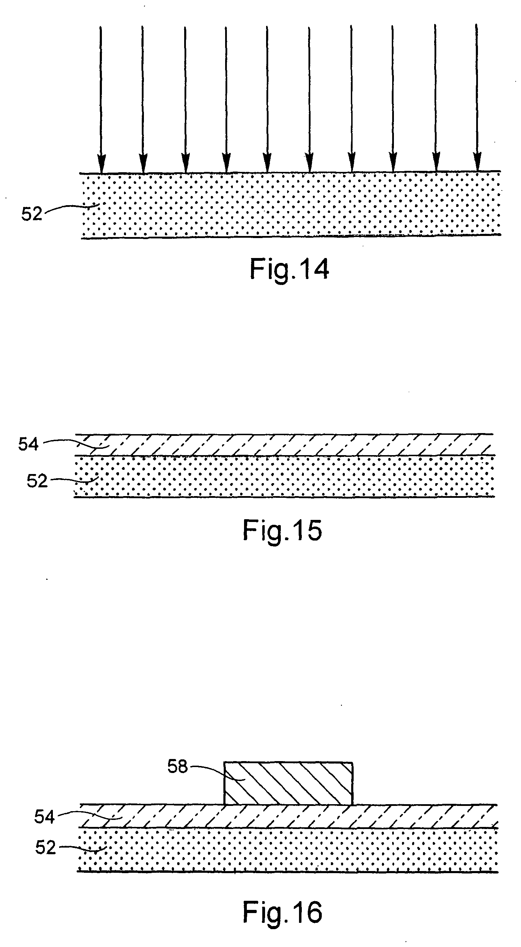

Les figures 14 à 16 illustrent un troisième mode de réalisation non compris dans l'invention revendiquée qui utilise cette possibilité.

Selon ce mode de réalisation, une couche 52 en oxyde de silicium (SiO₂) subit une implantation d'une espèce chimique (par exemple de l'arsenic) comme représenté schématiquement en figure 14.

Après implantation, la couche a donc globalement le profil représenté à la figure 15, soit une région surfacique 54 de la couche 52 ayant subi l'implantation et donc dopée en espèce chimique, alors que les régions enterrées de la couche 52 n'ont pas été touchées de manière substantielle par l'implantation.

On procède alors à la réalisation de la structure couche-motif, par exemple par formation du motif 58 selon un procédé analogue à celui représenté aux figures 1 et 2, ou en variante par report individuel ou collectif de motifs sur la surface implantée à l'aide d'un collage moléculaire par exemple.

Grâce au dopage des régions surfaciques 54 de la couche 52 en espèce implantée réalisée précédemment, les énergies de surface à l'interface couche-motif sont modifiées de manière à favoriser la tenue du motif 58 sur la couche 52.

On peut remarquer que ce mode de réalisation permet de réaliser assez facilement le dopage de la couche isolante par implantation d'espèces, notamment parce que le motif n'est pas présent lors de l'implantation. Cette solution permet en outre de faire réaliser l'implantation par le fournisseur de la couche 52 quand celui-ci n'est pas également le fabricant de la structure couche-motif.

Cette solution implique toutefois que toute la surface de la couche 52 est implantée, y compris la zone support du motif dans son intégralité, ce qui peut ne pas convenir dans certaines applications (risque de perte du caractère isolant de la couche 52 sous le motif 58 par exemple).

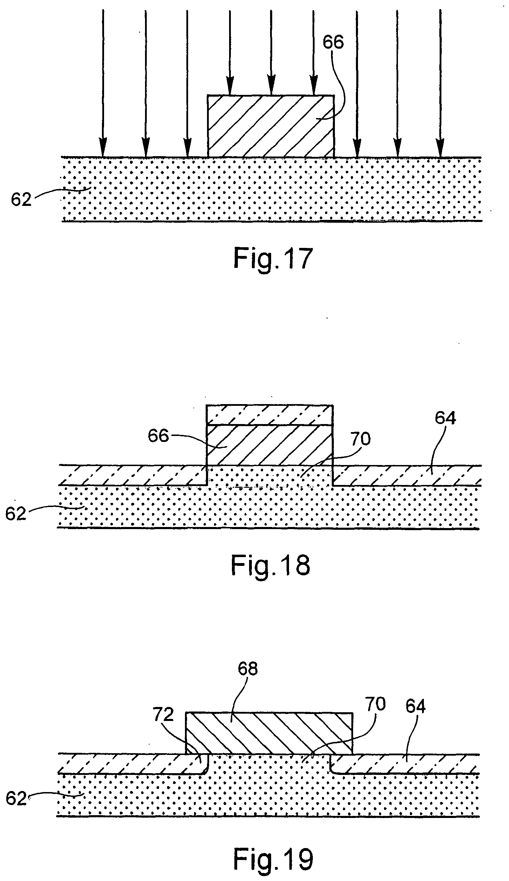

Un quatrième mode de réalisation de l'invention est représenté sur les figures 17 à 19.

Selon ce mode de réalisation, une couche d'isolant 62 est pourvue d'un masque 66 sur une partie de sa surface et soumise à une implantation d'espèces (par exemple d'arsenic), comme représenté à la figure 17.

Cette étape permet d'obtenir le dopage en espèces implantées d'une région 64 située à la surface de la couche 62, en dehors de la zone 70 de la couche 62 qui porte le masque 66, comme représenté à la figure 18. En effet, l'épaisseur du masque 66 et la profondeur typique d'implantation sont telles que l'implantation ne traverse pas substantiellement le masque 66 et laisse une zone 70 à composition chimique inchangée sous le masque 66.

On peut alors procéder à l'élimination du masque 66, puis au dépôt d'un motif mince 68, comme représenté à la figure 19. Comme indiqué précédemment, le motif mince 68 peut être réaliser par photo-lithogravure ou selon un procédé d'adhésion moléculaire.

On peut remarquer que, sur l'exemple représenté à la figure 19, la largeur du motif mince 68 est supérieure à la largeur du masque 66 utilisée lors de l'implantation, de telle sorte que des régions périphériques 72 de la zone de la couche 62 qui porte le motif 68 ont subi l'implantation et sont par conséquent dopées. En variante, le motif pourrait être légèrement à l'intérieur de la zone 70, en particulier si l'angle de Young est inférieur à 90°.

Comme dans les exemples précédents, on modifie ainsi l'angle de contact entre le motif 68 et la couche enterrée 62 de manière à stabiliser le motif 68 sur la couche 62.

Dans les exemples décrits ci-dessus, l'implantation est réalisée après ou avant la réalisation de la structure couche-motif. En variante, l'implantation en espèce chimique pourrait être réalisée de manière concomitante à la constitution de la structure couche-motif.

Les modes de réalisation qui viennent d'être décrits ne représentent que des exemples possibles de mise en œuvre de l'invention.

## Revendications

1. Procédé de fabrication d'un élément microélectronique en couches minces, dans lequel une couche (22) d'un premier matériau porte un motif (28) d'un second matériau ayant une épaisseur inférieure à 15 nm, le premier matériau étant un isolant en oxyde de silicium (SiO 2), et le second matériau étant un matériau semi-conducteur en silicium (Si), le procédé comprenant une étape de dopage par implantation, d'une espèce chimique, notamment des atomes d'arsenic (As) ou des atomes de phosphore (P), **caractérisé en ce que** l'implantation est réalisée avec une incidence non nulle sur une partie au moins de l'ensemble couche-motif de manière à modifier les propriétés surfaciques de ladite partie et notamment à modifier l'énergie d'interface entre la couche et le motif, et ainsi stabiliser le motif (28) sur la couche (22) par diminution de l'angle de contact, dit angle de Young, entre la couche en premier matériau et le motif en second matériau, l'implantation étant réalisée avec une profondeur typique dans la couche (22) en premier matériau inférieure à la moitié de l'épaisseur de ladite couche (22) en premier matériau.

2. Procédé selon la revendication 1, dans lequel l'implantation est réalisée au moins sur une partie de la couche (22) située à la périphérie d'une zone support du motif de manière à modifier les propriétés surfaciques de ladite partie.

3. Procédé selon la revendication 1 ou 2, dans lequel le motif (28) est porté par une face de la couche (22), dans lequel la face comprend une région (24) qui jouxte et entoure au moins en partie le motif et dans lequel l'implantation est réalisée au moins en partie sur ladite région (24).

4. Procédé selon l'une des revendications 1 à 3, dans lequel l'étape d'implantation laisse essentiellement inchangée la composition chimique d'au moins une partie de la zone de la couche (22) située directement sous le motif (28).

5. Procédé selon l'une des revendications 1 à 4, comprenant une étape de diffusion latérale de l'espèce implantée par recuit.

6. Procédé selon l'une des revendications 1 à 5, dans lequel le motif (28) est recouvert par un masque (26) lors de l'étape d'implantation.

7. Procédé selon la revendication 6, comprenant une étape préalable de formation du motif (28) par photo-lithogravure à l'aide du masque (26).

8. Procédé selon l'une des revendications 1 à 4, dans lequel l'implantation est réalisée au moins en partie dans le motif.

9. Procédé selon l'une des revendications 1 à 8, dans lequel la profondeur d'implantation typique réalisée dans la couche est inférieure à 50 nm.

10. Procédé selon l'une quelconque des revendications 1 à 9, **caractérisé en ce que** ladite incidence est comprise entre 5° et 45°.

11. Procédé selon l'une des revendications 1 à 10, dans lequel l'étape de dopage est postérieure à une étape de réalisation du motif (28).

12. Procédé selon l'une des revendications 1 à 10, dans lequel l'étape de dopage est antérieure à une étape de réalisation du motif.

## Patentansprüche

1. Verfahren zur Herstellung eines Mikroelektronik-Dünnschichtbauelements, bei dem eine Schicht (22) aus einem ersten Material ein Muster (28) aus einem zweiten Material trägt, welches eine Dicke von weniger als 15 nm aufweist, wobei es sich bei dem ersten Material um einen Isolator aus Siliciumoxid (SiO2) handelt, und wobei es sich beim zweiten Material um ein Halbleitermaterial aus Silicium (Si) handelt, wobei das Verfahren einen Schritt des Dotierens einer chemischen Spezies, insbesondere von Arsenatomen (As) oder Phosphoratomen (P), durch Implantation umfasst, **dadurch gekennzeichnet, dass** die Implantation an mindestens einem Teil der Schicht-/Muster-Einheit mit einem Einfall von ungleich null ausgeführt wird, um die Oberflächeneigenschaften des Teils zu modifizieren und insbesondere die Grenzflächenenergie zwischen der Schicht und dem Muster zu modifizieren und somit durch Verringerung des Youngscher Winkel genannten Kontaktwinkels zwischen der Schicht aus dem ersten Material und dem Muster aus dem zweiten Material das Muster (28) auf der Schicht (22) zu stabilisieren, wobei die Implantation mit einer typischen Tiefe in der Schicht (22) aus dem ersten Material ausgeführt wird, die kleiner ist als die Hälfte der Dicke der Schicht (22) aus dem ersten Material.

2. Verfahren nach Anspruch 1, wobei die Implantation mindestens an einem Teil der Schicht (22) ausgeführt wird, der am Rand einer Trägerzone des Musters liegt, um die Oberflächeneigenschaften des Teils zu modifizieren.

3. Verfahren nach Anspruch 1 oder 2, wobei das Muster (28) von einer Seite der Schicht (22) getragen wird, wobei die Seite eine Region (24) umfasst, die an das Muster angrenzt und dieses mindestens zum Teil umgibt, und wobei die Implantation mindestens zum Teil an der Region (24) ausgeführt wird.

4. Verfahren nach einem der Ansprüche 1 bis 3, wobei der Schritt des Implantierens die chemische Zusammensetzung mindestens eines Teils der Zone der Schicht (22), die direkt unter dem Muster (28) liegt, im Wesentlichen unverändert lässt.

5. Verfahren nach einem der Ansprüche 1 bis 4, das einen Schritt der lateralen Diffusion der implantierten Spezies durch Tempern umfasst.

6. Verfahren nach einem der Ansprüche 1 bis 5, wobei das Muster (28) beim Schritt des Implantierens mit einer Maske (26) abgedeckt wird.

7. Verfahren nach Anspruch 6, das einen vorausgehenden Schritt des Bildens des Musters (28) durch Photolithographie mit Hilfe der Maske (26) umfasst.

8. Verfahren nach einem der Ansprüche 1 bis 4, wobei die Implantation mindestens zum Teil im Muster ausgeführt wird.

9. Verfahren nach einem der Ansprüche 1 bis 8, wobei die typische Tiefe einer Implantation, die in der Schicht ausgeführt wird, weniger als 50 nm beträgt.

10. Verfahren nach einem der Ansprüche 1 bis 9, **dadurch gekennzeichnet, dass** der Einfall zwischen 5° und 45° liegt.

11. Verfahren nach einem der Ansprüche 1 bis 10, wobei der Schritt des Dotierens nach einem Schritt des Herstellens des Musters (28) erfolgt.

12. Verfahren nach einem der Ansprüche 1 bis 10, wobei der Schritt des Dotierens vor einem Schritt des Herstellens des Musters erfolgt.

## Claims

1. A method of fabricating a thin-film microelectronic member, in which a layer (22) of a first material carries a pattern (28) of a second material having a thickness of less than 15 nm, the first material being a silicon oxide (SiO 2) insulator, and the second material being a silicon (Si) semiconductor material, the method comprising a step of doping by implantation, of a chemical species, in particular arsenic atoms (As) or phosphorus atoms (P), **characterized in that** the implantation is carried out with a non-zero angle of incidence on at least part of the layer-pattern assembly so as to modify the surface properties of said part and in particular to modify the interface energy between the layer and the pattern, and thus stabilize the pattern (28) on the layer (22) by reducing the contact angle, known as Young's angle, between the layer of first material and the pattern of second material, the implantation being carried out with a typical depth in the layer (22) of first material of less than half the thickness of said layer (22) of first material.

2. A method according to claim 1, in which the implantation is carried out at least on a portion of the layer (22) at the periphery of a support area of the pattern so as to modify the surface properties of said portion.

3. A method according to claim 1 or 2 in which the pattern (28) is carried by a surface of the layer (22) in which the surface comprises a region (24) that adjoins and surrounds at least part of the pattern and in which the implantation is carried out at least in part over said region (24).

4. A method according to one of claims 1 to 3, in which the implantation step leaves essentially unchanged the chemical composition of at least a portion of the area of the layer (22) directly under the pattern (28).

5. A method according to one of claims 1 to 4, comprising a step of laterally diffusing the implanted chemical species by annealing.

6. A method according to one of claims 1 to 5, in which the pattern (28) is covered by a mask (26) during the implantation step.

7. A method according to claim 6, comprising a prior step of forming the pattern (28) by photolithographic etching using the mask (26).

8. A method according to one of claims 1 to 4, in which the implantation is carried out at least in part into the pattern.

9. A method according to one of claims 1 to 8, in which the typical depth of implantation carried out in the layer is less than 50 nm.

10. A method according to any one of claims 1 to 9, **characterized in that** said angle of incidence is comprised between 5° and 45°.

11. A method according to one of claims 1 to 10, in which the doping step follows a step of producing the pattern (28).

12. A method according to one of claims 1 to 10, in which the doping step precedes a step of producing the pattern.
